# EUROPEAN PATENT APPLICATION

(11) **EP 3 667 705 A1**
(43) Date of publication of application: **17.06.2020**
(21) Application number: 19215188.4
(22) Date of filing: 15.04.2013
(51) Int. Cl.: H01L 21/302, H01L 21/02, B08B 7/00, H01L 21/67

(54) **METHOD AND SYSTEM FOR DELIVERY OF PURIFIED MULTIPLE PHASES OF CARBON DIOXIDE TO A PROCESS CHAMBER**

(30) Priority: 17.04.2012 US 201261625265 P
(62) Divisional of application: 13778890.7
(71) Applicant: Praxair Technology, Inc., Danbury, CT 06810 (US)
(72) Inventor: BANERJEE, Souvik, Freemont, CA 94536 (US); GERRISTEAD, William, R., Grand Island, NY 14072 (US)
(74) Representative: Schwan Schorer & Partner mbB

(57) **Abstract**

The application relates to a method for delivering different phases of carbon dioxide to create a customized cleaning sequence (200, 300, 400) for the removal of contaminants from a surface of a substrate (110). The application further relates to a supply system for purifying and delivering multiple phases of carbon dioxide to a downstream process chamber (111). The ability for the supply system to deliver vapor, liquid and supercritical phases of carbon dioxide in a specific sequence (200, 300, 400) at predetermined times during a process cleaning sequence (200, 300, 400) produces an improved removal of contaminants from the substrate (110, ) compared to conventional carbon dioxide cleaning processes.

## Description

### Field of the Invention

The present invention relates to a carbon dioxide supply system and method based on a novel process sequence for removal of contaminants from a substrate surface. Specifically, the process involves introduction into a process chamber a combination of different carbon dioxide phases, including supercritical carbon dioxide, to create a specific cleaning sequence designed to remove byproduct contaminants without damaging the device features formed on the substrate.

### Background of the Invention

Dynamic Random Access Memory (DRAM) manufacturers continue to investigate and develop device scaling with high Aspect Ratio (AR) stacked microelectronic device features, such as, for example, cylindrical capacitors. The International Technology Roadmap for Semiconductors (ITRS) has indicated that AR's greater than, for example, 50:1 at 32 nm node and below will be required to maintain sufficient capacitance for next-generation capacitors. Such AR's for microelectronic device features continue to increase to meet the ever increasing need for processing speed and memory density of integrated circuits.

The fabrication of high AR microelectronic features can include several processing steps, such as, for example, patterning, etching and deposition of materials to produce the device features. Conductive features can be formed within a sacrificial layer which is thereafter removed by an etchant solution. The etchant solution and byproduct are typically rinsed and dried with deionized water and/or organic solvents. However, the conductive features are prone to collapse during etching, cleaning and drying by virtue of the surface tension of deionized water and organic solvents. The occurrence of such feature collapse is becoming more frequent and problematic, as the width dimensions of structures continue to decrease and their AR's continue to increase.

One method for reducing feature collapse is the use of supercritical carbon dioxide as the solvent for etching, cleaning, and drying of such features. Supercritical carbon dioxide does not have any surface tension. As a result, device structures would not collapse when in contact with supercritical carbon dioxide. Nonetheless, drawbacks exist with the use of supercritical carbon dioxide. For instance, during formation of supercritical carbon dioxide, the liquid carbon dioxide is pressurized and heated to at least the supercritical phase of 7,4 MPa (1072 psi) and 31 °C, during which time impurities contained in the liquid carbon dioxide, such as Non Volatile Organic Residues (NVOR's) and metals, can dissolve into the supercritical carbon dioxide. These impurities manifest themselves as particulate defects on the wafer surface at the end of process. The net effect is that the microelectronic features are unusable. To compound the problem, the etch byproducts generated during etching with supercritical carbon dioxide tend to have relatively low solubility in the supercritical carbon dioxide and, as a result, will tend to precipitate onto the wafer surface. In some cases, the precipitates of the etch byproducts may adversely alter the functionality of the resultant microelectronic device. As a consequence, the precipitant material needs to be removed by a wet rinse. However, as mentioned, utilizing wet rinse processes having high AR device structures tends to cause feature collapse by virtue of the surface tension of the solvents.

Accordingly, the need for eliminating residual byproducts during etching, cleaning and drying of a substrate would be advantageous.

In US 2004/142564 A1 there is described a method of post chemical mechanical polishing (CMP) cleaning to remove a CMP residue from a surface of an object is disclosed. The object is placed within a pressure chamber. The pressure chamber is pressurized. A supercritical carbon dioxide process is performed to remove a residual CMP residue from the surface of the object. The pressure chamber is vented.

In US 6562146 B1 there is described a method of cleaning and removing water and entrained solutes during a manufacturing process from a microelectronic device such as a resist-coated semiconductor substrate, a MEM's device, or an optoelectronic device comprising the steps of: (a) providing a partially fabricated integrated circuit, MEM's device, or optoelectronic device having water and entrained solutes on the substrate; (b) providing a densified (e.g., liquid or supercritical) carbon dioxide drying composition, the drying composition comprising carbon dioxide and a drying adjunct, the drying adjunct selected from the group consisting of cosolvents, surfactants, and combinations thereof; (c) immersing the surface portion in the densified carbon dioxide drying composition; and then (d) removing the drying composition from the surface portion.

### Summary of the Invention

The invention relates to a carbon dioxide supply method and system for removing contaminants from a substrate, in particular a semiconductor wafer. The timing and sequence for delivering a combination of various carbon dioxide phases, together with the processing conditions for such delivery, have been found to affect the ability to remove contaminants from a substrate surface, resulting in an improved substrate treatment process that is particularly advantageous for semiconductor processing applications.

It has been found that during processing of a semiconductor substrate with supercritical carbon dioxide, other phases of carbon dioxide can facilitate and enhance the removal of contaminants from a substrate surface. The introduction into a process chamber of a combination of carbon dioxide phases including supercritical carbon dioxide creates a specific cleaning sequence designed to remove byproduct contaminants while maintaining the structural integrity of the high AR microelectronic devices. The carbon dioxide supply method and system is capable of removing contaminants from progressively smaller device features without causing damage to such features. The process is conducive for removing contaminants within high Aspect Ratio (AR) stacked microelectronic device features, such as, for example, cylindrical DRAM capacitors or Shallow Trench Isolations, and others.

In one aspect the invention is a method for delivering different phases of carbon dioxide to create a customized cleaning sequence for the removal of contaminants from a surface of a substrate as it is defined in claim 1. The method includes introducing pure gas phase carbon dioxide to pressurize the chamber to a first pressure below a saturated vapor pressure; removing the pure gas phase and subsequently introducing carbon dioxide in a supercritical phase to increase the chamber pressure from the first pressure to a second pressure higher than the first pressure; introducing a solvent fluid at the second pressure comprising carbon dioxide in a supercritical phase mixed with co-solvents into a chamber containing the substrate; transferring contaminants from the substrate surface into the supercritical carbon dioxide phase to form at least a partially spent supercritical phase of carbon dioxide; removing the at least partially spent supercritical carbon dioxide phase from the chamber and simultaneously introducing fresh carbon dioxide in the supercritical phase without the co-solvents into the chamber so as to dilute the spent supercritical carbon dioxide and substantially inhibit the contaminants from precipitating onto the substrate surface; subsequently introducing pure carbon dioxide in a liquid phase into a chamber; and flowing the carbon dioxide liquid phase over the substrate surface to flush and rinse the substrate surface and thereby remove the contaminants and any co-solvents residually remaining on the substrate surface.

In another aspect the invention is a supply system for purifying and delivering multiple phases of carbon dioxide to a downstream chamber as it is defined in claim 4. The supply system includes a first accumulator positioned between a purification unit and the chamber, the first accumulator comprising saturated liquid phase carbon dioxide and saturated vapor phase carbon dioxide; a second accumulator positioned between the purification unit and the chamber, the second accumulator comprising supercritical phase carbon dioxide; a purification unit positioned upstream of the first and the second accumulators to produce purified carbon dioxide from a bulk tank containing crude carbon dioxide; and a flow network positioned at the outlet of the first and the second accumulators and having a first leg, a second leg, a third leg, a first control valve a second control valve and a third control valve.

Advantageously, the carbon dioxide supply system can be constructed utilizing system components that are commercially available, thus enabling and simplifying the overall assembly of the system and method of use thereof. Aspects of purified carbon dioxide delivery to a process tool can be carried out using standard techniques or equipment.

### Brief Description of the Figures

The objects and advantages of the invention will be better understood from the following detailed description of the preferred embodiments thereof in connection with the accompanying figures wherein:
Fig. 1 illustrates a fragmentary schematic of a process for storing and supplying carbon dioxide incorporating the principles of the present invention;
Fig. 2 illustrates a first process sequence selectively utilizing specific phases of carbon dioxide for cleaning a wafer incorporating the principles of the present invention;
Fig. 3 illustrates a second process sequence selectively utilizing specific phases of carbon dioxide for cleaning a wafer incorporating the principles of the present invention;
Fig. 4 illustrates a third process sequence selectively utilizing specific phases of carbon dioxide for cleaning a wafer incorporating the principles of the present invention;
Fig. 5 illustrates another embodiment of a carbon dioxide purification and supply system incorporating the principles of the present invention; and
Fig. 6 shows the vapor pressure as a function of fluid temperature from 20 °C to a supercritical temperature of 31.1 °C.

### Detailed Description of the Invention

The above and other features of the invention including various details of construction and combinations of parts, and other advantages, will now be more particularly described with reference to the accompanying drawings and pointed out in the claims. It will be understood that the particular carbon dioxide supply system and method of delivery embodying the invention are shown by way of illustration and not as a limitation of the invention. The principles and features of this invention may be employed in various and numerous embodiments without departing from the scope of the invention.

As used herein and in the claims, all concentrations are expressed as volumetric or mole percentages. As used herein and in the claims, the term "contaminants" refers to solid particles, non-volatile residue ("NVR"), and non-volatile organic residue ("NVOR"), metals and any other byproducts produced as a result of cleaning, etching and rinsing various microelectronic device features, and any remaining co-solvents. Solid particles, also known as inhomogeneous contaminants, typically refers to small (e.g., microscopic) pieces of metal shed by machinery used in the carbon dioxide application and any contaminants generated from the process which is not soluble in carbon dioxide at a given pressure and temperature. Generally, solid contaminants do not dissolve in high pressure or subcritical carbon dioxide. NVR refers to that portion of contaminants that remains following sublimation or evaporation of the carbon dioxide at room temperature and pressure. A portion of this NVR will typically consists of solid particles, such as may have shed from metal surfaces during processing as described above. A further portion of the NVR typically consists of NVOR which is that portion of the NVR that is soluble in carbon dioxide at some pressure and temperature. Examples include aliphatic hydrocarbon-based heavy oils, halocarbons, and particulate matter that is soluble in carbon dioxide under certain conditions but can precipitate out at other pressure and temperature conditions, e.g., during lowering of the chamber pressure at the end of the process. Sources of NVOR include compressor oils and elastomeric materials that have some solubility in liquid carbon dioxide and are commonly found in in the original carbon dioxide or could come from the chamber components such as gaskets and valve seat materials. In clean distribution systems, the majority of the NVR present is commonly in the form of NVOR.

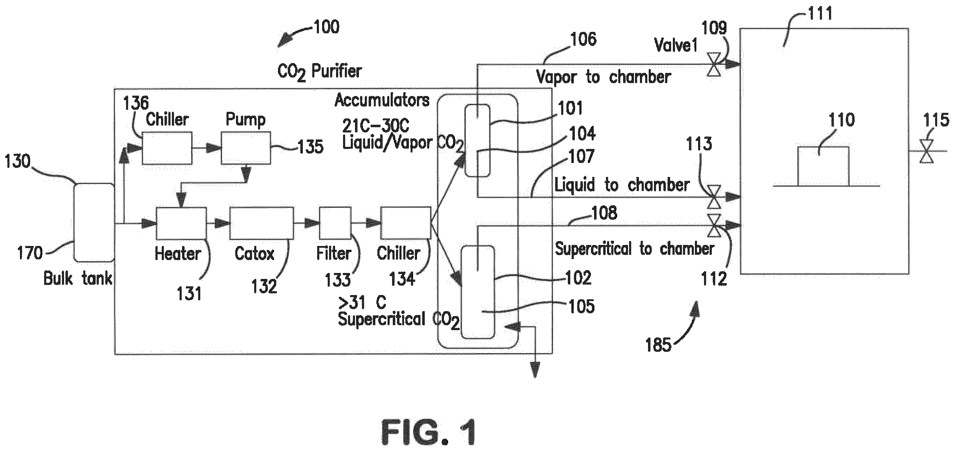

Figure 1 shows an exemplary carbon dioxide purification and supply system 100 in accordance with the principles of the present invention. The purification and supply system 100 can have a small footprint, comparable to a typical gas cabinet, so that it can be positioned in the sub-fabrication area of a device manufacturer's production facility. The system 100 is designed for delivery of multiple phases of purified carbon dioxide to a downstream process chamber 111. Various phases of purified carbon dioxide are stored in accumulators 101 and 102. Specifically, stored carbon dioxide 104 is stored as saturated liquid and saturated vapor carbon dioxide in the first accumulator 101. Supercritical carbon dioxide 105 is stored in the second accumulator 102. As will be explained, each of the phases of the saturated liquid and vapor carbon dioxide can be removed from the first accumulator 101, and the supercritical carbon dioxide 105 can be removed from the second accumulator 102, in a specific manner, and directed into a process chamber 111 to remove contaminants from a substrate 110.

The delivery of purified saturated liquid or vapor carbon dioxide 104 from the first accumulator 101 and the delivery of purified supercritical carbon dioxide 105 from the second accumulator 102 is enabled by a flow network 185 that connects the first and the second accumulators 101 and 102 to the process chamber 111 containing a substrate 110 therewithin. The flow network 185 is positioned at the outlet of the first and the second accumulators 101 and 102. The network 105 includes a first leg 106, a second leg 107 and a third leg 108, a first control valve 109, a second control valve 113 and a third control valve 112.

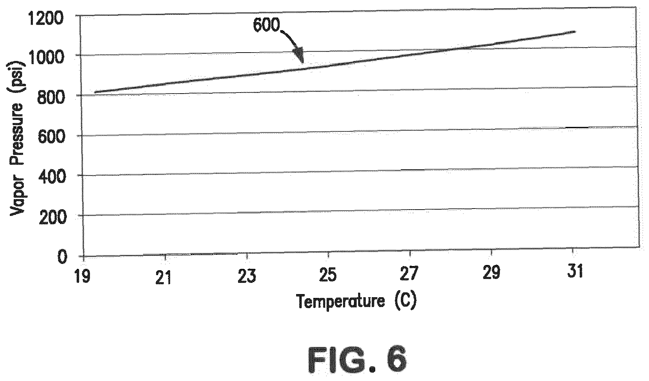

Figure 1 shows an exemplary purification process for purifying crude carbon dioxide 170 that is stored in a bulk tank 130. The purification unit consists of chillers 134 and 136, an optional pump 135, a heater 131, a catox reactor 132 and a particulate filter 133. The crude carbon dioxide 170 may be stored in the bulk tank 130 as a liquid phase at pressures ranging from about 2,2 MPa (300 psig) to about 5.6 MPa (800 psig) at ambient temperature. The crude carbon dioxide 170 in this example has a purity of 99.9%. It should be understood that other purity levels for the crude carbon dioxide 170 are contemplated. The purification unit can purify the crude carbon dioxide 170 from the bulk tank 130 to 99.999%, with <1 ppb metals and <50 ppb NVOR's. The purified carbon dioxide is then delivered to the first accumulator 101 and the second accumulator 102 for temporary storage prior to being delivered to a process tool 111 to remove contaminants from a substrate 110. Pressure and temperature control for each accumulator 101 and 102 enables the stored carbon dioxide 104 in accumulator 101 to be maintained in their desired phases. The temperature and pressure of the first accumulator 101 is controlled to enable the stored carbon dioxide 104 to coexist as a saturated liquid in equilibrium with its saturated vapor. In one example, the temperature in the accumulator 101 ranges between about 21°C to about 30 °C, with the pressure being equal to the vapor pressure exerted by the vapor phase carbon dioxide therein. The vapor pressure curve 600 exerted by vapor phase carbon dioxide is shown in Figure 6. The temperature and pressure of the second accumulator 102 is preferably controlled to enable the stored carbon dioxide 104 to exist in a supercritical phase. In one example, the supercritical phase of carbon dioxide is defined by a temperature greater than or equal to 31.1 °C and a pressure greater than 7,5 MPa 1072 psig).

Figure 1 shows one possible technique for purifying the crude carbon dioxide 170 stored within the bulk tank 130. Carbon dioxide 170 flows from the bulk tank 130 through a heater 131 to raise its fluid pressure. The heater 131 can raise the liquid carbon dioxide temperature from a liquid CO2 temperature to about 400 °C, thereby converting the liquid carbon dioxide to vapor phase carbon dioxide. The increased pressure of the carbon dioxide exiting heater 131 is the vapor pressure corresponding to the heated temperature of the carbon dioxide by heater 131, in accordance with the vapor pressure curve 600 for carbon dioxide shown in Figure 6. Pressures which are higher than the vapor pressure may be generated by employing an optional pump 135. Preferably, however, pumps are not used to avoid introducing contaminants into the vapor phase carbon dioxide exiting the Catox 132.

After vapor phase carbon dioxide flows through heater 131, it may enter the catox reactor 132 at a temperature ranging from about 175°C to about 400 °C. The catox reactor 132 includes a suitable catalyst, such as a precious and/or nonprecious metal. Hydrocarbon molecules, which form the NVOR's in carbon dioxide, react with O₂ in the reactor in the presence of heat and the catalyst to form carbon dioxide and water. The catox reactor 132 also helps in breaking down the halocarbons in carbon dioxide in the presence of moisture. Details for removing contaminants from the carbon dioxide by employing the catox reactor 132 are disclosed in U.S. Patent No. 6,962,629.

The purified carbon dioxide vapor is heated in the catox reactor 132 and then flows through a particulate filter 133 (e.g., 0.003 µm pore size) to remove any inorganic and metallic particulates which were not oxidized in the catox reactor 132. The purified carbon dioxide vapor exits the particle filter 133 and then flows through a chiller or a heat exchanger 134 to reduce its temperature by a predetermined amount. In one embodiment, a heat exchanger 134 is employed and comprised of two coiled tube heat exchangers. The cooling can be provided in these heat exchangers 134 through the use of cold water flowing in the outer coil of the heat exchanger tubes.

The carbon dioxide is cooled, condensed and flows with sufficient pressure from the outlet of the heat exchanger 134 into one of two accumulators 101 or 102 for subsequent delivery to a process tool 111. Supercritical carbon dioxide 105 can be achieved in corresponding accumulator 102 by pressurizing and heating accumulator 102 as required. To generate the necessary higher pressures at a given temperature to attain supercritical carbon dioxide in the second accumulator 102, pump 135 can be employed. The independent control of the pressure and temperature of the stored supercritical carbon dioxide phase 105 allows the user to have process flexibility for a variety of different processing conditions. For example, different wafer cleaning processes in semiconductor applications may require different densities of supercritical carbon dioxide, which can be tuned by its pressure and temperature. One batch of wafers might require processing at a supercritical phase of carbon dioxide at 20.78 MPa (3000 psig) and 35C, while another batch might require the supercritical phase of carbon dioxide to be at 10,44 MPa (1500 psig) and 35C.

Stored carbon dioxide 104 consists of saturated liquid-vapor carbon dioxide, which can be maintained and stored in accumulator 101 (i.e., a subcritical phase of carbon dioxide) by heating accumulator 101 independent from accumulator 102. The carbon dioxide fluid in the liquid/vapor accumulator 101 will equilibrate to its vapor pressure at that temperature corresponding to the vapor pressure curve 600 of carbon dioxide, as shown in Figure 6. The pressures in the accumulator 101 can be attained and maintained solely by heating, as in the above description of the purification flow path of crude carbon dioxide 170 from the bulk tank 130.

Each of the accumulators 101 and 102 preferably will have a port to sample the concentration of the stored carbon dioxide 104 and 105 and detect for impurities (e.g., metals and NVOR contaminants). The analysis of the carbon dioxide can be performed by any method known in the art, such as, for example, GC-MS (Gas Chromatogram with Mass Spectrometer) and ICP-MS (Inductively Coupled Plasma Mass Spectrometer). Details of one exemplary sampling method are disclosed in U.S. Patent No. 7,064,834. *In-situ* sampling for contaminants contained in the stored carbon dioxide 104 and 105 allows an operator to check the quality of the stored carbon dioxide 104 and 105 in accumulators 101 and 102, respectively, before it is delivered into the downstream processing tool 111 and contacts the surface of a substrate 110. In the semiconductor industry, the ability to conduct such *in-situ* sampling allows detection of impure stored carbon dioxide 104 and 105 before contamination of a batch of semiconductor wafers.

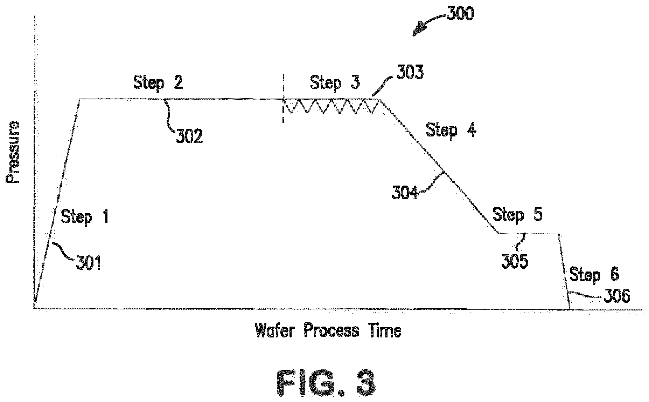

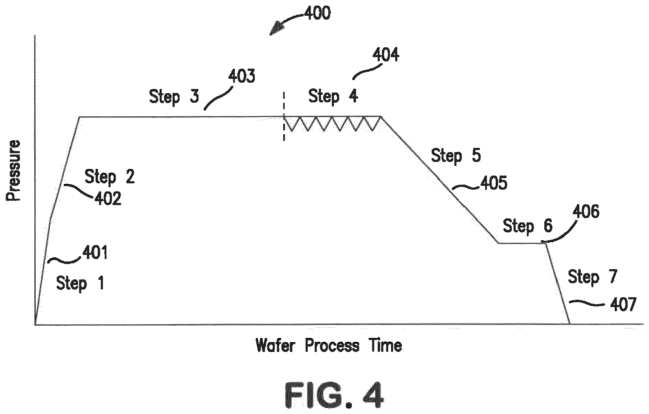

The above purification process of crude carbon dioxide 170 contained in the bulk tank 130 is merely an illustrative embodiment. It should be understood that other means for purifying the carbon dioxide into accumulators 101 and 102 is contemplated. For instance, a filtration system may be employed for purifying other gases besides carbon dioxide. In one embodiment, the purification unit could incorporate a filtration system for purifying gases such as helium, nitrogen, argon and other gases which do not mix with carbon dioxide and which remain in the gas phase at the working pressure of the process tool 111. Such gases could be used as a pusher gas that is introduced into the process tool 111 during the de-pressurization steps 304 and 405 shown in Figures 3 and 4, which will be explained below.

By separately maintaining the control of temperature and pressure in accumulator 101 independent from the control of temperature and pressure in accumulator 102, the various phases of vapor, liquid and supercritical carbon dioxide are simultaneously available on-demand to create novel cleaning sequences of a substrate 110, as will now explained.

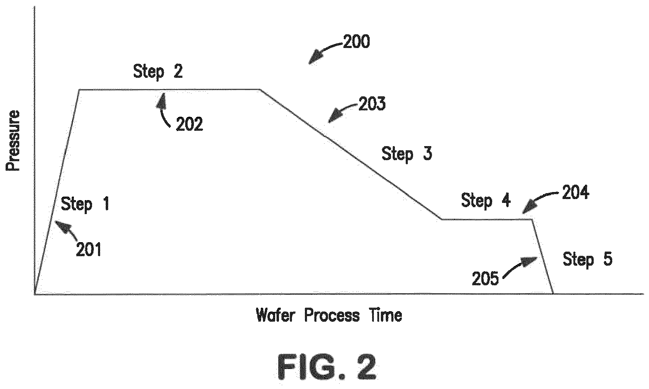

Fig. 2 shows a first embodiment of a process sequence 200 for removal of contaminants contained on a substrate 110. The process sequence 200 can be performed utilizing the carbon dioxide supply system 100 of Figure 1. As will be explained, by selectively delivering supercritical and non-supercritical phases of carbon dioxide to the process chamber 111 in a predetermined manner, a customized sequence for removal of contaminants from the surface of the substrate 110 is achieved. Process sequence 200 has five steps. The first step 201 involves pressurizing the process chamber 111 by introducing supercritical carbon dioxide into the chamber 111. The supercritical carbon dioxide may be stored at a temperature greater than 31.1 °C and pressure greater than of 7,5 MPa 1072 psig) within the second accumulator 102. Valve 112 is set in an open position from the second accumulator 102 of Figure 1. Because the supercritical carbon dioxide is at a higher pressure than the process chamber 111, the supercritical carbon dioxide can exit second accumulator 102 and flows through leg 108 of the outlet flow network 185 into the process chamber 111 without use of a pump or compressor. Valve 115 is maintained in a closed position so that the pressure in chamber 111 increases to at/ least the supercritical point of the carbon dioxide. After the desired supercritical pressure is introduced within the chamber 111, the valve 112 connecting the second accumulator 102 to the chamber 111 is also closed to isolate the chamber 111 so that cleaning of the substrate 110 can occur with the supercritical carbon dioxide.

In step 202, the chamber 111 is maintained at a working pressure of at least 7,4 MPa (1072 psi) and a temperature of 31.1 °C. During this time, other chemical reagents known as co-solvents can be introduced into the chamber 111 for cleaning or etching of the substrate 110. For purposes of clarity, the co-solvent injection path has not been shown in Figure 1. The substrate 110 remains soaked with supercritical carbon dioxide and the optional co-solvents. As a result, the supercritical carbon dioxide can extract and remove contaminants from within the spaces of the high AR features, which liquid carbon dioxide cannot extract because of its surface tension. The absence of surface tension in the supercritical carbon dioxide allows the high AR features to be cleaned without collapsing or buckling. Contaminants from the substrate 110 become entrained into the supercritical carbon dioxide by virtue of the contaminants' solubility within the supercritical carbon dioxide. In this manner, the features are cleaned without damage. As removal of contaminants continues, the supercritical carbon dioxide within the chamber 111 approaches a spent state in which its solubility limit may be attained.

When the contaminants have been determined to be sufficiently extracted and removed, and/or when the supercritical carbon dioxide has attained its solubility limit, depressurization of the chamber 111 occurs at Step 203. Typically, the end of step 202 and start of step 203 will be determined experimentally by varying the duration of step 202, as well as pressure, temperature, co-solvents, etc. Once it is determined that a certain set of parameters work for a given process, then when running in production, the time for Step 202 is set in the process "recipe" and the wafer cleaning/etching tool automatically goes to the next step after the time elapses. The spent supercritical carbon dioxide, along with any co-solvent and additives introduced during step 202, is removed in a depressurization procedure. Step 203 shows a linear de-pressurization to a certain pressure level at which point liquid CO2 is flowed in a rinse mode in step 204). Depressurization continues until the pressure in the chamber is below the supercritical point. In one example, the pressure in the chamber is reduced to about 850 psi.

Following the controlled depressurization, step 204 of the cleaning sequence 200 can begin. The supply of fresh supercritical carbon dioxide into chamber 111 stops by closing valve 112, which connects the second accumulator 102 containing supercritical carbon dioxide to the process chamber 111. Valve 113 is opened to allow access to accumulator 101, which contains stored carbon dioxide 104 in the form of saturated liquid carbon dioxide in equilibrium with its vapor phase carbon dioxide. During step 204, saturated liquid carbon dioxide is drawn from the bottom of the accumulator 101 and then directed through leg 107 of flow network 185 into the chamber 111. The liquid carbon dioxide is discharged from the first accumulator 101 at a pressure greater than the pressure in the chamber 111. The liquid carbon dioxide enters the chamber 111 at a relatively low flow rate dictated by the pressure differential between chamber 111 and the accumulator 101 so as to not damage any of the high AR features contained on the substrate 110. The liquid carbon dioxide facilitates removal of contaminants which might have re-deposited onto the surface of the substrate 110 during the de-pressurization step of 203. The liquid carbon dioxide continuously flows over the surface of the substrate 110. The drag force of the liquid carbon dioxide enables the contaminants along the substrate 111 to be moved, thereby allowing the flushing and rinsing of contaminants across the surface of the substrate 110. Additionally, the higher density of the liquid carbon dioxide facilitates the solubility of any re-deposited contaminants into the liquid carbon dioxide. Discharge valve 115 is opened to allow liquid carbon dioxide to flow in a flow-through mode between the accumulator 101 and the chamber 111. In this example, preferably, the pressure of the liquid carbon dioxide in the first accumulator 101 is sufficiently high to avoid pumping, d into the chamber 111. When liquid carbon dioxide cleaning is completed, valve 113 is closed.

At step 205, the chamber 111 can be vented until the pressure in the chamber reduces to atmospheric pressure. Upon the chamber 111 being vented to atmospheric pressure, the cleaned substrate 110 can be removed from the chamber 111. This embodiment for removal of contaminants contained on a substrate 110 illustrates how successively delivering a combination of supercritical carbon dioxide and liquid carbon dioxide at predetermined times during a process cleaning sequence can provide improved removal of contaminants from the substrate 110 compared to conventional carbon dioxide cleaning processes. Supercritical carbon dioxide is initially introduced to extract contaminants from the high AR features without causing such features to collapse or buckle, while liquid carbon dioxide is subsequently flowed along the substrate at low flow rates to remove any re-deposited contaminants on the surface of the substrate 110 by virtue of the liquid carbon dioxide drag force and higher solubility of the contaminants in the liquid carbon dioxide. Such a synergistic combination of supercritical carbon dioxide followed by liquid carbon dioxide cleaning can improve removal of the contaminants.

Figure 3 illustrates another embodiment of a cleaning sequence 300 for removal of contaminants contained on a substrate 110. The process sequence 300 can be performed utilizing the carbon dioxide supply system 100 of Figure 1. Process sequence 300 has six steps. The first step 301 involves pressurizing the process chamber 111 by introducing supercritical carbon dioxide from the second accumulator 102. The supercritical carbon dioxide may be stored in the second accumulator 102 at a temperature of 32 °C and pressure of 7,4 MPa (1072 psi). Valve 112 is set in an open position from the second accumulator 102 of Figure 1 and valve 115 can be configured in the closed position. In this example, the chamber 111 may be pressurized up to about 1500 psi, which represents the process or working pressure of the supercritical carbon dioxide for cleaning of the substrate 110.

When the desired working pressure in the process chamber 111 is achieved, valve 112 is closed. The cleaning sequence at step 302 can now begin utilizing the supercritical carbon dioxide that has been introduced from the previous step 301. The cleaning with the supercritical carbon dioxide occurs in the same manner as described in the cleaning sequence 200 of Figure 2. Co-solvents and optional other additives can be introduced as known in the art. The co-solvents or additives added to supercritical carbon-dioxide are instrumental in accomplishing the process of etching or drying. Supercritical carbon dioxide acts as a medium to dissolve the active ingredients or the co-solvents and the byproducts of the reactions. For etching, the co-solvents comprise, by way of representative example, etching chemicals such as fluoride, pyridine, or combinations thereof. For drying, the co-solvents can be isopropanol. Other examples of suitable cleaning and etching chemicals are provided in US Patent publication 2007/0293054 A1 by Lee et.al.

When the extraction of contaminants by supercritical carbon dioxide is completed, a bleed and feed dilution procedure occurs at step 303. Valve 112 is open to allow fresh supercritical carbon dioxide to be introduced into the chamber 111, and valve 113 is open to allow spent supercritical carbon dioxide to be removed from the chamber 111. The fresh supercritical carbon dioxide is introduced at a pressure approaching the working pressure, while spent supercritical carbon dioxide is removed from the chamber 111 at approximately the same flow rate at which the fresh supercritical carbon dioxide is introduced. Such processing conditions for the "bleed and feed" allow the chamber 111 to be maintained at a pressure substantially close to the process or working pressure (i.e., the pressure at which supercritical carbon dioxide removed and extracted contaminants in step 302) while successively diluting portions of the spent supercritical carbon dioxide. The resultant pressure profile is shown to be slightly saw-tooth as fresh supercritical carbon dioxide enters the chamber 111 and spent supercritical carbon dioxide exits the chamber 111. The pressure spikes are a result of the pressure in the second accumulator 102 being higher in comparison to the chamber 111. The slightly lower series of drops in pressure are attributed to the removal of spent supercritical carbon dioxide from the chamber 111. This slight predetermined pressure difference that is intentionally maintained between the second accumulator 102 and the chamber 111 is sufficient for the fresh supercritical carbon dioxide to flow into the chamber 111. The average pressure in the chamber remains relatively constant so that the overall "bleed and feed" is conducted at about a constant pressure that is equal to the working pressure in previous step 302.

When the constant pressure bleed and feed step 303 is completed, valve 112 is closed to cease the supply of supercritical carbon dioxide into the chamber 111. Depressurization step 304 can now occur. The process chamber 111 can be vented below the supercritical pressure of carbon dioxide, to a pressure in the range of about 2,1 MPa (300 psi) to about 6,9 MPa (1000 psi), as shown in step 304, keeping the pressure in chamber 111 below the pressure in the accumulator 101 to allow liquid carbon di-oxide to flow into the chamber. When the pressure in the chamber 111 has been sufficiently depressurized, valve 112 is closed and valve 113 is opened to allow liquid carbon dioxide to flow from the bottom of the first accumulator 101 into the process chamber 111, as shown in the flush and rinse step 305. Step 305 is a flow through rinse in which liquid carbon dioxide flows along the surface of the substrate 110. The liquid carbon dioxide ensures removal of any residual contaminants that may still be present on the surface of the substrate 110 or might have re-deposited during the depressurization step 304.

The density of the liquid carbon dioxide is sufficient to allow the contaminants on the substrate 111 to be dissolved into the liquid carbon dioxide. Additionally, the liquid carbon dioxide has a sufficient drag force that can remove the contaminants disposed along the substrate 111. As a result, submicron contaminants may be removed in the flush and rinse step 305.

Following the flush and rinse step 305, valve 113 is closed to stop the supply of liquid carbon dioxide through leg 107 and into the process chamber 111. The chamber 111 is depressurized to atmospheric pressure as shown in step 306 to vent the remaining liquid and/or supercritical carbon dioxide from chamber 111.

As can be seen, the carbon dioxide supply system 100 with accumulators 101 and 102 and corresponding flow network 185 with valves 109, 112 and 113 allow the pressure profile of each of the steps in the process sequence 300 to be controlled so as to create improved removal of contaminants without damaging the high AR features along the surface of the substrate 110. Supercritical carbon dioxide is first introduced to extract contaminants from small AR features without buckling such features. Liquid carbon dioxide is subsequently introduced to dissolve residual contaminants and also push the contaminants contained along the substrate surface by virtue of the liquid carbon dioxide's drag force. The ability to deliver supercritical and liquid carbon dioxide in a specific process sequence and on-demand during the cleaning sequence 300 is made possible by the supply system 100 of Figure 1.

Figure 4 illustrates another embodiment of a cleaning sequence 400 for removal of contaminants contained on the substrate 110. Similar to the previous embodiments, this process sequence 400 can be carried out utilizing the carbon dioxide supply system of Figure 1. In this embodiment of the present invention, the pressurization of the chamber 111 to the working pressure is achieved in discrete stages. Specifically, the first step 401 involves pressurizing the chamber 111 with saturated vapor carbon dioxide from the first accumulator 101. In this regard, valve 109 is set in the open position. The saturated vapor in the first accumulator 101 has a greater pressure than the chamber 111, which is initially at atmospheric pressure. As a result, the saturated vapor carbon dioxide is able to flow through leg 106 of flow network 185 into the chamber 111. Valve 115 downstream of chamber 111 is preferably maintained in the fully closed position to enable the pressure in the chamber 111 to rise. The pressure inside the chamber 111 is held at below the saturated vapor pressure at the specified temperature of the chamber 111. Accordingly, the carbon dioxide exists within the chamber 111 as a gas phase without any liquid-vapor boundary. In this manner, the chamber 111 can be advantageously pressurized without significant liquid condensation by virtue of the Joule Thompson expansion of the carbon dioxide that enters chamber 111. Even though cooling of the gas-phase carbon dioxide may occur upon expansion in chamber 111 and the pressure in the chamber 111 will need to increase through the saturation vapor pressure to achieve the working pressure and working temperature in the chamber 111, the two-step approach to pressurization in step 401 of Figure4 can substantially minimize adverse liquid formation as typically encountered in conventional cleaning processes.

The gas-phase carbon dioxide is not saturated at the temperature within chamber 111. Accordingly, the elimination of liquid condensation during pressurization of the chamber 111 at step 401 circumvents the surface tension effects inherent in liquid carbon dioxide, which can potentially damage the high AR pattern features on the substrate 110.

The gas-phase pressurization of step 401 can be performed relatively fast, compared to the flush and rinse of step 406, as the pressure in the chamber 111 is maintained below saturation vapor pressure. When delivery of the gas-phase carbon dioxide into the chamber 111 causes the pressure to rise to a predetermined pressure that is below the saturated vapor pressure, valve 109 is closed to stop the flow of the vapor phase carbon dioxide from the top of first accumulator 101, and valve 112 is opened to begin flow of supercritical phase carbon dioxide 104 from the second accumulator 102 into the chamber 111. In one example, the predetermined pressure reaches about 800 psig at temperature of about 31°C prior to switching from gas-phase carbon dioxide to supercritical phase carbon dioxide to ensure that the pressure in chamber 111 is below the saturation vapor pressure of carbon dioxide.

With valve 109 closed and valve 112 opened, supercritical carbon dioxide 105 pressurizes the chamber 111 from a pressure below saturation pressure to the final working pressure. Supercritical carbon dioxide is introduced through leg 108 of flow network 185 and into the chamber 111. The corresponding pressure rise for this step is shown at step 402.

The balance of the steps for the cleaning sequence 400 is identical to that described in Figure 3. Specifically, step 403 involves the use of supercritical carbon dioxide at step 403 to remove and extract contaminants from the features of the substrate 110. Co-solvents or additives can also be added to the chamber 111 in this step 403. A constant pressure bleed and feed is performed at step 404. Following the constant pressure bleed and feed, a depressurization occurs at step 405 in which the process chamber 111 is vented below the supercritical pressure of carbon dioxide, to a pressure in the range of about 2,1 MPa (300 psi) to about 6,9 MPa (1000 psi). When the pressure in the chamber 111 has been sufficiently depressurized, liquid carbon dioxide is introduced for a flush and rinse of any remaining contaminants (step 406).

Accordingly, the process sequence 400 of Figure 4 requires three different phases of carbon dioxide at specific times during the cleaning sequence - gas-phase carbon dioxide, supercritical carbon dioxide and liquid carbon dioxide. The supply system 100 of Figure 1 allows the ability to deliver each of these phases of carbon dioxide to the process chamber 111 as required in a specific sequence to produce an improved cleaning sequence in comparison to conventional processes.

Still referring to Figure 4, an alternative embodiment for conducting step 401 would involve pulse venting or cycle purging. The introduction of gas-phase carbon dioxide would occur in pulses so as to displace the air from the chamber 111. Thermal control in the chamber 111 is maintained by such pulse venting to maintain a relatively constant temperature in the chamber 111. In this embodiment, the ramp up of pressure occurs in a series of discrete steps whereby incremental pressurization in the chamber is followed by slight venting of the chamber 111 to displace air and also mitigate the cooling of the carbon dioxide that would occur upon the vapor carbon dioxide expanding into the chamber 111. This continual pulse purging in step 401 occurs in a saw-tooth profile. By displacing air from the chamber 111 with gas-phase carbon dioxide, the introduction of additional carbon dioxide into the chamber 111 may not cool as much in temperature. In other words, the introduction of gas-phase carbon dioxide into the chamber, in a pulse-like manner, may equilibrate the temperature in the chamber 111 to make possible thermal control and the avoidance of localized cooling. Accordingly, performing steps 401 and 402 substantially avoids the formation of two-phase carbon dioxide in the chamber 111. As such, step 402 can occur by filling the chamber 111 with supercritical carbon dioxide to achieve the working pressure without undesirably going through the liquid-vapor boundary, and its associated adverse surface tension effects, particularly on high AR features contained on the substrate 110. This is one example of pulse venting that can be employed to potentially enhance thermal control while also maintaining substantially non-saturated conditions of the carbon dioxide in the chamber 111.

It should be understood that other variations to Figure 4 are contemplated by the present invention. For example, a bellows chamber could be used in the following manner. The process chamber 111 could be initially pressurized to a first pressure prior to supplying the supercritical carbon dioxide into the process chamber. The first pressure would be approximately equal to about a supercritical pressure of the carbon dioxide. Air or an inert gas could be utilized to pressurize to the first pressure. After the process chamber 111 has attained the first pressure, supercritical carbon dioxide can be supplied into the process chamber 111, with the supercritical carbon dioxide being delivered to the chamber 111 at a second pressure greater than the first pressure. The step of supplying supercritical carbon dioxide at the second pressure comprises configuring and modulating a bellows chamber to compress the supercritical carbon dioxide to the second pressure. Pressures losses incurred by the supercritical carbon dioxide during the supply to the chamber 111 remains insufficient so as to not cause the supercritical carbon dioxide to reduce to a subcritical carbon dioxide phase. The supercritical carbon dioxide displaces the air or inert gas upon entering the chamber 111.

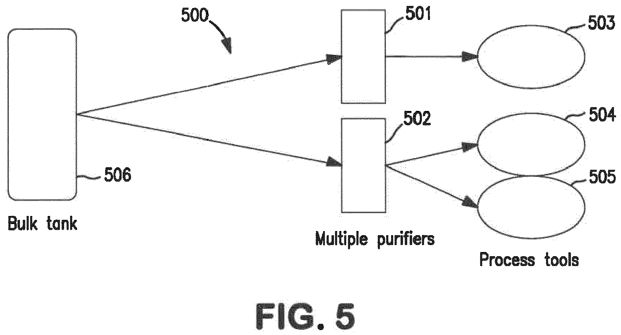

It should be further understood that the principles of the present invention can be extended to multiple purification and process systems to serve multiple process tools. Figure 5 illustrates a purification and supply system 500 comprising multiple purification and supply units. Each purification and supply system 501 and 502 may be configured as shown and described with reference to Figure 1. However, unlike Figure 1 each purification and supply system 501 and 501 can be connected to one or more process tools. Figure 5 shows that purification and supply system 501 is connected to a single process tool 503, while purification and supply system 502 is connected to process tools 504 and 505. Bulk tank 506 contains stored carbon dioxide in crude form. The crude carbon dioxide in bulk tank 506 can be purified by purification and supply system 501 or 502. Valving in the purification and supply system of 500 has been omitted for purposes of clarity. This purification and supply system 500 allows a compact footprint to advantageously serve multiple processing tools simultaneously.

While this invention has been particularly shown and described with references to preferred embodiments thereof, it will be understood by those skilled in the art that various changes in form and details may be made therein without departing from the scope of the invention encompassed by the appended claims.

## Claims

1. A method for delivering different phases of carbon dioxide to create a customized cleaning sequence for the removal of contaminants from a surface of a substrate, comprising the steps of:
introducing pure gas phase carbon dioxide to pressurize the chamber to a first pressure below a saturated vapor pressure;
removing the pure gas phase and subsequently introducing carbon dioxide in a supercritical phase to increase the chamber pressure from the first pressure to a second pressure higher than the first pressure;
introducing a solvent fluid at the second pressure comprising carbon dioxide in a supercritical phase mixed with co-solvents into a chamber containing the substrate;
transferring contaminants from the substrate surface into the supercritical carbon dioxide phase to form at least a partially spent supercritical phase of carbon dioxide;
removing the at least partially spent supercritical carbon dioxide phase from the chamber and simultaneously introducing fresh carbon dioxide in the supercritical phase without the co-solvents into the chamber so as to dilute the spent supercritical carbon dioxide and substantially inhibit the contaminants from precipitating onto the substrate surface;
subsequently introducing carbon dioxide in a liquid phase into a chamber; and
flowing the carbon dioxide liquid phase over the substrate surface to flush and rinse the substrate surface and thereby remove the contaminants and any co-solvents residually remaining on the substrate surface.

2. The method of claim 1, wherein the step of introducing the pure phase carbon dioxide is performed using a cycle pulse purge, whereby air is being displaced with the pure phase carbon dioxide.

3. The method of claim 1, wherein a rate for attaining the first pressure is greater than a rate for attaining the second pressure.

4. A supply system for purifying and delivering multiple phases of carbon dioxide to a downstream process chamber, comprising:
a first accumulator positioned between a purification unit and the chamber, the first accumulator comprising saturated liquid phase carbon dioxide and saturated vapor phase carbon dioxide;
a second accumulator positioned between the purification unit and the chamber, the second accumulator comprising supercritical phase carbon dioxide;
a purification unit positioned upstream of the first and the second accumulators to produce purified carbon dioxide from a bulk tank containing crude carbon dioxide; and
a flow network positioned at the outlet of the first and the second accumulators and having a first leg, a second leg, a third leg, a first control valve a second control valve and a third control valve.

5. The supply system of claim 4, wherein each of the accumulators comprise heaters to achieve set point pressures.

6. The supply system of claim 4, wherein the second accumulator is a bellows chamber.

7. A method for preventing contaminants from precipitating onto a substrate surface during cleaning of the substrate, comprising the steps of:
pressurizing the process chamber to a first pressure, wherein the first pressure is at least equal to about a supercritical pressure of carbon dioxide; and
supplying supercritical carbon dioxide into the process chamber, wherein the supercritical carbon dioxide is delivered to the chamber at a second pressure greater than the first pressure.

8. The method of claim 7, wherein the step of supplying supercritical carbon dioxide comprises configuring and modulating a bellows chamber to compress the supercritical carbon dioxide to the second pressure.

9. The method of claim 7, wherein the step of pressurizing the process chamber to a first pressure comprises pressurizing the process chamber with air or an inert gas prior to supplying the supercritical carbon dioxide into the process chamber.

10. The method of claim 7, wherein pressures losses incurred by the supercritical carbon dioxide during the supply to the chamber remains insufficient so as to not cause the supercritical carbon dioxide to reduce to a subcritical carbon dioxide phase.
